# EUROPEAN PATENT APPLICATION

(11) **EP 1 818 427 A2**
(43) Date of publication of application: **15.08.2007**
(21) Application number: 07002034.2
(22) Date of filing: 31.01.2007
(51) Int. Cl.: C25D 5/54, C25D 3/12, C25D 3/38

(54) **Improved method for the direct metallization of non-conductive substrates**

(30) Priority: 08.02.2006 DE 102006005684
(71) Applicant: ENTHONE, INCORPORATED, West Haven, CT 06516 (US)
(72) Inventor: Königshofen, Andreas, Dr., 51371 Leverkusen (DE); Kesseler, Corinna, 46159 Oberhausen (DE)
(74) Representative: Stenger, Watzke & Ring

(57) **Abstract**

The present invention relates to an improved method for the metallization of an electrically non-conductive substrate using a thiosulphate conductor. According to the invention, thiosulphate conductors are used in combination with compounds of the ions of the group consisting of lithium, potassium, rubidium, caesium or mixtures thereof.

## Description

The present invention relates to a method for the direct metallization of non-conductive substrates. Furthermore, the invention relates to a treatment solution for generating a first conductive layer on electrically non-conductive substrates for the deposition of a metal or alloy layer.

From the state of the art different methods for the direct metallization of non-conductive substrates, such as printed circuit boards or structural parts made of plastic, are known.

The German Patent DE 33 23 476 for instance discloses a method for the galvanic metallization of articles having at least one non-metallic surface to be at least partially metallized. Herein, in a first treatment step, metallic seeds or particles are applied to the surface to be metallized. In a subsequent process step, the pretreated substrates are introduced into an electroplating bath that contains as additional components methylene blue, methyl violet, alkylphenoxypolyethoxyethanols, non-ionic fluorocarbons, polyoxyethylene compounds, block copolymers of polyoxyethylene and polyoxypropylene, allylthiocarbamides, tetramethylthiuramide sulphide, 2,4,6-(2-pyridyl)-s-triazine, a nitrogen comprising heterocyclic compound, triphenylmethane colours, thiocarbamides or thiourea derivates, saccharine as well as o-benzaldehydesulphonic acid derivates. Furthermore, it is known from the European Patent Application EP 0 538 006 to metallize electrically non-conductive substrates by means of a method, in which in a first treatment step the substrates to be metallized are contacted with a palladium-tin activator, wherein palladium seeds settle down on the surface of the substrate. After such an activation, a post-activation in a metal salt solution is carried out which comprises a metal that can be reduced by a metal of the activator solution, a complexing agent as well as at least one metal of the group lA.

The thus prepared substrates can afterwards be acidically metallized.

From the American Patent US 5,238,550 a method for the metallization of electrically non-conductive substrates is known, in which a precious metal colloid that is absorbed on the surface of the substrate is converted into corresponding chemically stable metal sulphides which serve as base for a direct metallization. Herein, in a first treatment step, the substrates are covered with precious metal colloids, preferably palladium tin colloids. In a subsequent treatment step the precious metal colloids that are present on the surface of the non-conductive substrate are converted into corresponding metal sulphides by means of a basic thiosulphate solution.

From US 4,895,739 a comparative method is known, in which the precious metal colloids that have been deposited on the surface in a first treatment step are also converted into suitable metal chalcogenes.

All methods have in common that the substrates to be metallized have to be conditioned in a suitable manner before a metallization. Usually, such a conditioning is carried out by means of suitable etching baths, such as for example dichromate-sulphuric acid etch. Depending on the nature of the related metallization method, the chosen etching conditions have a clear influence on the final metallization result.

The treatment conditions during the activation or post-activation of the non-conductive substrates, such as for example the chosen temperature or eventual movements of the substrate in the treatment solution during the contacting, have another influence on the metallization result.

Therefore, the metallization methods known from the state of the art can often only be used in limited application fields, either because of the chosen process parameters, the selected etching bath or the plastic to be metallized.

It is thus the **object** of the present invention to provide a method for the metallization of an electrically non-conductive substrate that has a wide application range and can in particular be employed if very different etching baths are used.

This aim is achieved by a method for the metallization of an electrically non-conductive substrate, at least comprising the following process steps:
contacting the substrate with a metal containing activator solution,
contacting the substrate that has been contacted with the metal containing activator solution with a treatment solution that at least contains a thiosulphate,
deposition of a metal or alloy layer or conductive metal compound layer on the treated substrate,
that is characterized in that the thiosulphate containing treatment solution at least contains a ion of the group consisting of lithium, potassium, rubidium, caesium or mixtures thereof.

Surprisingly it has been found in tests carried out by the applicant that the addition of ions of the group consisting of lithium, potassium, rubidium, caesium or mixtures thereof leads to clearly better metallization results, if thiosulphate containing treatment solutions are used.

In particular it has been found that the addition of the above mentioned ions to the thiosulphate containing treatment solutions leads to good metallization results, even in case of unfavourable pre-treatment conditions, such as for instance different etching baths for the conditioning of the plastic surface to be metallized. Furthermore, the deposition results are also good within wide temperature ranges if the thiosulphate treatment solution according to the invention is used. Using the thiosulphate treatment solution according to the invention does not only enable copper to be very well deposited, but also nickel as first metal layer.

Furthermore, it has been found as very advantageous that the use of the thiosulphate containing treatment solutions leads to a high independence of the metallization methods with respect to mechanical influences, such as for example the flow of electrolyte against the substrate in the metallization bath or during the activation.

Advantageously, the ions of the group consisting of lithium, potassium, rubidium, caesium or mixtures thereof are added to the thiosulphate containing treatment solution in form of a compound of the group consisting of fluorides, chlorides, bromides, nitrates, sulphates or mixtures thereof. Hereby, an influence on the pH value of the thiosulphate containing treatment solution by adding the mentioned compounds is almost avoided.

As thiosulphate source of the thiosulphate containing treatment solution all suitable thiosulphate sources can serve. Furthermore, compounds such as for example polythionic acids which release thiosulphate under alkaline conditions can serve as thiosulphate source. Advantageously, sodium thiosulphate or silver thiosulphate are used as thiosulphate source.

The thiosulphate containing treatment solution advantageously presents an alkaline pH value within the range of > pH 9, advantageously within the range comprised between pH 11.5 and pH 13.5.

Corresponding alkaline or alkaline earth hydroxides can be used as alkalization agent. Advantageously, a alkali hydroxide is added for setting the pH value.

Furthermore, the thiosulphate containing treatment solution according to the invention contains a complexing agent. Suitable complexing agents are tartaric acid derivates, such as for example potassium sodium tartrate, ethylenediamine tetraacetic acid (EDTA), citrate or other suitable chelatization reagents for the colloid metal that has been introduced in the activation step.

In a test series, ABS plastic surfaces were conditioned with different etching baths. The examined etching baths were a dichromate-sulphuric acid etch having a chromium trioxide content of 350 g/l, a sulphuric acid content of 400 g/l and a chromic content of about 5 g/l on the one hand, and a chromic acid etch having a chromium trioxide content of about 1000 to 1100 g/l and a chromic content of about 50 to 60 g/l. Both etch types were respectively doted with 20 mg/l palladium.

The plastic surfaces conditioned in the thus obtained etching baths were afterwards activated by means of a standard palladium tin activator.

After the activation of the surfaces, these ones were post-activated with different treatment solutions, wherein the respective treatment solutions contained different conductors. As conductors respectively copper sulphate, potassium iodide, sodium thiosulphate as well as a mixture of sodium thiosulphate and tetraminopalladium-(II)-chloride were used. Besides the conductors, the alkaline treatment solutions contained a complexing agent such as for example potassium sodium tartrate as well as a ion of the group consisting of lithium, potassium, rubidium, caesium or mixtures thereof in the form of a compound of the group consisting of fluorides, chlorides, bromides, nitrates, sulphates or mixtures thereof.

The thus prepared plastic surfaces were afterwards metallized in either a standard acid copper electrolyte or in a standard nickel electrolyte.

Under all test conditions, the combination of a thiosulphate conductor and a ion of the mentioned group proved to be the most efficient pre-treatment method.

Under the chosen conditions which were an electroplating for three minutes at 3 Ampere for the copper electrolyte and an electroplating for one minute at 2 Volt and for two minutes at 3 Volt for the nickel electrolyte, the treated plastic surfaces usually showed a complete covering after three minutes.

The following exemplary embodiment exemplarily shows the method according to the invention for the metallization of an electrically non-conductive substrate, wherein the invention however is not limited to the concrete exemplary embodiment.

### Example 1

An ABS workpiece is etched for 10 minutes at 66°C in a dichromate-sulphuric acid that contains 350 g/l chromium trioxide, 400 g/l sulphuric acid, 15 g/l chromic and 20 g/l palladium. Afterwards, it is rinsed and activated for 4 minutes at 40°C in a Pd/Sn activator that consists of 300 ml/l concentrated hydrochloric acid, 15 g/l tin (II) and 250 mg/l palladium. It is rinsed again and post-treated for 4 minutes at 55°C in a conductor solution, wherein 3 different basic compositions (see table 1) are tested. The ABS workpieces are thoroughly rinsed with demineralised water, dried and the surface resistance is measured. After the measurement, all three conductor solutions are mixed with 0.013 mol/l sodium thiosulphate and the tests are repeated. Afterwards, 0.6 mol/l lithium chloride is respectively added to all three conductor solutions and the above described tests are repeated. It has been found that the surface resistance could be reduced by more than 50% in all three solutions by adding lithium chloride.

**Table 1: surface resistance on ABS workpieces**

| Conductor solution | 1 mol/l NaOH 0.25 mol/l tartaric acid | 1 mol/l NaOH 0.25 mol/l K-Na-tartrate | 1 mol/l NaOH 0.25 mol/l K-Na-tartrate 0.2 mmol [Pd(NH₃)₄]Cl₂ |
|---|---|---|---|
| | 95 kΩ | 77 kΩ | 69 kΩ |
| + 0.13 mol/l Na thiosulphate | 2.5 kΩ | 1.8 kΩ | 2.2 kΩ |
| + 0.6 mol/l LiCl | 1.2 kΩ | 0.7 kΩ | 0.9 kΩ |

### Example 2

In a DOE (design of experiment) it is tested which conductor composition permits the widest field of application. For this, identical ABS workpieces were slipped on identical holders, etched, activated, treated in the conductor solution and metallized. For this four different conductor solutions were tested, the composition of which is listed in table 2. Other variables were two different etching baths, two different motional intensities in the activator solution and two different electrolytes for the metallization. The conditions of these variables are listed in table 3 and respectively called A or B.

**Table 2: Composition of the conductor solutions, treatment parameters: respectively 4 minutes at 55°C**

| | solution 1 | solution 2 | solution 3 | solution 4 |
|---|---|---|---|---|
| NaOH | 1 mol/l | 1 mol/l | 1 mol/l | 1 mol/l |
| K-Na-tartrate | 0.25 mol/l | 0.25 mol/l | 0.25 mol/l | 0.25 mol/l |
| LiCl | 0.6 mol/l | 0.6 mol/l | 0.6 mol/l | 0.6 mol/l |
| CuSO₄ 5aq | 0.016 mol/l | | | |
| K iodide | | | | 0.012 mol/I |
| Na thiosulphate | | 0.013 mol/l | 0.013 mol/l | |
| [Pd(NH₃)₄]Cl₂ | | 0.2 mmol/l | | |

**Table 3: description of the DOE variables**

| DOE variables | A | B |
|---|---|---|
| Metallization | 5 litres commercial blasted nickelsulfamate electrolyte (Elpelyt Monolith) at 45°C with 2 anodes: metallization 1 minute at 2 Volt, then 2 minutes at 3 Volt | 5 litres commercial blasted copper electrolyte (Cuprostar 1525) at 25°C with 2 anodes: metallization 3 minutes at 3 Ampere |
| Etching bath | Chromic acid etch comprising 1100 g/l CrO₃, 55 g/l Cr³⁺ and 20 mg/l palladium: 16 minutes at 67°C | Dichromate sulphuric acid etch comprising 350 g/l CrO3, 400 g/l H₂SO₄, 15 g/l Cr³⁺ and 20 mg/l palladium: 8 minutes at 67°C |
| Activator solution | 300 ml/l HCl (37%), 15 g/l Sn(II), 250 mg/l palladium: 4 minutes at 40°C and agitation speed of 700 revolutions/minute | 300 ml/l HCl (37%), 15 g/l Sn(II), 250 mg/l palladium: 4 minutes at 40°C and agitation speed of 300 revolutions/minute |

According to DOE, 8 experiments were carried out in all 4 conductor solutions, wherein the order was chosen according to the random principle. In table 4 the covering with metal layer is indicated which was achieved after a metallization of respectively 3 minutes. In the letter combination of DOE the first letter always indicates the type of metallization bath, the second letter indicates the kind of etching bath and the third letter the agitation speed of the activator. Combination ABA means for example according to table 3: nickel-plated, etched in chromic sulphuric acid, activated at 700 r/min.

**Table 4: % covering (front and rear face) after 3 minutes metallization**

| | AAA | AAB | ABA | ABB | BAA | BAB | BBA | BBB |
|---|---|---|---|---|---|---|---|---|
| Solution 1 | 60 | 60 | 98 | 50 | 80 | 100 | 100 | 100 |
| Solution 2 | 80 | 90 | 100 | 90 | 75 | 30 | 100 | 100 |
| Solution 3 | 100 | 97 | 100 | 65 | 100 | 100 | 100 | 100 |
| Solution 4 | 50 | 85 | 100 | 20 | 100 | 5 | 100 | 100 |

In table 4 one can see that solution 3 gives the best metallization result for nearly all combinations. Only for the combination ABB solution 2 was better than solution 3.

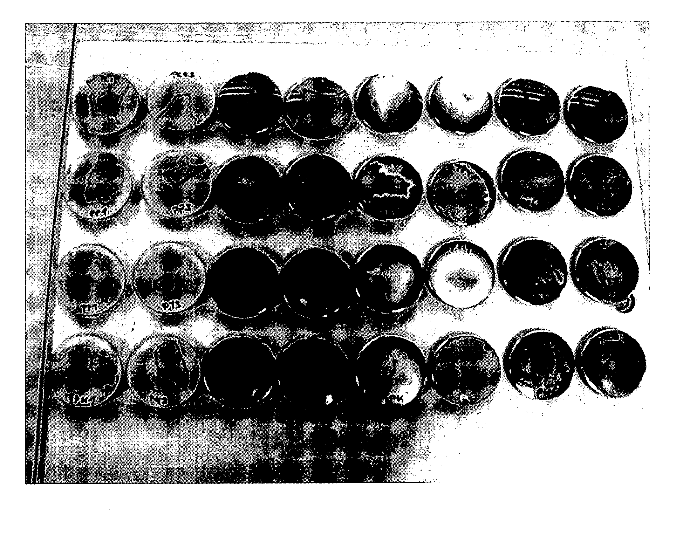

Fig. 1 shows the test substrates listed in table 4. The arrangement corresponds to the order indicated in table 4.

## Claims

1. A method for the metallization of an electrically non-conductive substrate, at least comprising the process steps:
- contacting the substrate with a metal containing activator solution,
- contacting the substrate that has been contacted with the metal containing activator solution with a treatment solution that at least contains a thiosulphate,
- deposition of a metal or alloy layer on the treated substrate,
**characterized in that**
the thiosulphate containing treatment solution at least contains a ion of the group consisting of lithium, potassium, rubidium, caesium or mixtures thereof.

2. A method according to claim 1, **characterized in that** the at least one ion of the group consisting of lithium, potassium, rubidium, caesium or mixtures thereof is added to the treatment solution in form of a compound of the group consisting of fluorides, chlorides, bromides, nitrates, sulphates or mixtures thereof.

3. Thiosulphate containing treatment solution for producing a first conductive layer for the galvanic deposition of a metal or alloy layer or metal compound layer on an electrically non-conductive substrate,
**characterized in that**
the treatment solution at least contains one ion of the group consisting of lithium, potassium, rubidium, caesium or mixtures thereof.
